(19) Europäisches Patentamt
European Patent Office
Office européen des brevets

(11) **EP 2 889 633 B1**

(12) **EUROPEAN PATENT SPECIFICATION**

(45) Date of publication and mention
of the grant of the patent:
**25.09.2019 Bulletin 2019/39**

(51) Int Cl.:
*G01R 31/36* *(2019.01)*    *H01M 10/48* *(2006.01)*
*H02J 7/00* *(2006.01)*

(21) Application number: **14175227.9**

(22) Date of filing: **01.07.2014**

(54) **Battery deterioration determining apparatus for electric vehicle and method thereof**

Vorrichtung zur Bestimmung der Batterieverschlechterung für ein Elektrofahrzeug und Verfahren dafür

Appareil de détermination de détérioration de batterie pour véhicule électrique et procédé associé

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.12.2013 KR 20130150698**

(43) Date of publication of application:
**01.07.2015 Bulletin 2015/27**

(73) Proprietor: **Hyundai Motor Company
Seoul 137-938 (KR)**

(72) Inventor: **Nam, Jiwon
000-000 Gyeonggi-do (KR)**

(74) Representative: **Isarpatent
Patent- und Rechtsanwälte Behnisch Barth
Charles
Hassa Peckmann & Partner mbB
Friedrichstrasse 31
80801 München (DE)**

(56) References cited:
**EP-A2- 2 530 478       FR-A1- 2 977 678
FR-A1- 3 011 393        US-A1- 2001 022 518
US-A1- 2003 071 599**

EP 2 889 633 B1

## Description

The present invention relates to a battery degradation determining apparatus and method according to the preamble of independent claims 1 and 4, respectively, which are known form FR 2 977 678 A1.

A similar batter degradation determining apparatus and method are disclosed in US 2003/071559 A1.

EP 2 530 478 A2 discloses a condition determination device for determining a condition of an electric storage device including a current detector, a voltage detector, and a controller.

The controller is configured to detect charging currents and voltages and to determine a condition of the electric storage device based thereon.

US 2001/0022518 A1 discloses a capacity estimation method, degradation estimation method and degradation estimation apparatus for lithium-ion batteries.

### _(b) Description of the Related Art

An electric vehicle uses a battery-powered motor operating by electrical energy output by a battery. Since the electric vehicle mainly uses a battery formed of one battery pack that includes a plurality of rechargeable/dischargeable secondary cells, the electrical vehicle advantageously outputs no emission gases and low noise. A hybrid vehicle commonly refers to a gasoline-electric hybrid vehicle that uses gasoline to power an internal-combustion engine and an electric battery to power an electric motor.

As such, since performance of an electric vehicle depends on performance of a battery, a battery management system is required that manages charge and discharge of each battery cell by measuring a voltage of each battery cell and voltage and current of the entire battery, and guarantees performance of the battery cell by determining degradation of each battery cell. Particularly, the battery used for the electric vehicle is degraded by continuous usage, and therefore performance of the battery deteriorates. When the performance of the battery deteriorates, travel distance is reduced and output of the vehicle during acceleration under same state of charge (SOC) is degraded.

The above information disclosed in this section is merely for enhancement of understanding of the background of the invention and therefore it may contain information that does not form the prior art that is already known in this country to a person of ordinary skill in the art.

### SUMMARY

A battery degradation determining apparatus for an electric vehicle according to the present invention is defined in independent claim 1.The battery degradation determining apparatus for an electric vehicle may further include a degradation determiner also executed by the controller and configured to determine whether the battery is degraded using the degradation of the battery calculated by the degradation calculator. Further, the time for maintaining the constant voltage mode may increase exponentially based on the degradation of the battery. The time for maintaining the constant voltage mode is from a time when a voltage of the battery reaches the predetermined voltage by the constant current mode to a time when an SOC of the battery reaches a predetermined level.

A determining method of battery degradation for an electric vehicle according to the present invention is defined in independent claim 4.

The condition determining degradation of the battery is satisfied when the temperature of a battery is within a room temperature range. The time for maintaining the constant voltage mode is from a time when a voltage of the battery reaches the predetermined voltage by the constant current mode to a time when an SOC of the battery reaches a predetermined level. The degradation determiner may be configured to determine that the battery is degraded when the degradation degree of the battery is greater than a predetermined level, and the degradation determiner may be configured to output an alarm indicating an inspection of the battery to a driver.

### BRIEF DESCRIPTION OF THE DRAWINGS

The drawings are provided for reference in describing exemplary embodiments of the present invention, and the spirit of the present invention should not be construed only by the accompanying drawings.

FIG. 1 is an exemplary graph illustrating a time for maintaining a constant voltage mode according to a degradation degree of a battery for an electric vehicle according to an exemplary embodiment of the present invention;

FIG. 2 is an exemplary graph illustrating a relationship of a time for maintaining a constant voltage mode and degradation of a battery for an electric vehicle according to an exemplary embodiment of the present invention;

FIG. 3 is an exemplary block diagram illustrating a battery degradation determining apparatus for an electric vehicle according to an exemplary embodiment of the present invention; and

FIG. 4 is an exemplary flowchart illustrating a determining method of battery degradation for an electric vehicle according to an exemplary embodiment of the present invention.

### DETAILED DESCRIPTION

The present invention will be described more fully hereinafter with reference to the accompanying drawings, in which exemplary embodiments of the invention are shown. As those skilled in the art would realize, the described embodiments may be modified in various different ways, all without departing from the spirit or scope of the present invention.

It is understood that the term "vehicle" or "vehicular" or other similar term as used herein is inclusive of motor vehicles in general such as passenger automobiles including sports utility vehicles (SUV), buses, trucks, various commercial vehicles, watercraft including a variety of boats and ships, aircraft, and the like, and includes hybrid vehicles, electric vehicles, plug-in hybrid electric vehicles, hydrogen-powered vehicles and other alternative fuel vehicles (e.g. fuels derived from resources other than petroleum). As referred to herein, a hybrid vehicle is a vehicle that has two or more sources of power, for example both gasoline-powered and electric-powered vehicles.

Although exemplary embodiment is described as using a plurality of units to perform the exemplary process, it is understood that the exemplary processes may also be performed by one or plurality of modules. Additionally, it is understood that the term controller refers to a hardware device that includes a memory and a processor. The memory is configured to store the modules and the processor is specifically configured to execute said modules to perform one or more processes which are described further below.

Furthermore, control logic of the present invention may be embodied as non-transitory computer readable media on a computer readable medium containing executable program instructions executed by a processor, controller or the like. Examples of the computer readable mediums include, but are not limited to, ROM, RAM, compact disc (CD)-ROMs, magnetic tapes, floppy disks, flash drives, smart cards and optical data storage devices. The computer readable recording medium can also be distributed in network coupled computer systems so that the computer readable media is stored and executed in a distributed fashion, e.g., by a telematics server or a Controller Area Network (CAN).

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items.

Unless specifically stated or obvious from context, as used herein, the term "about" is understood as within a range of normal tolerance in the art, for example within 2 standard deviations of the mean. "About" can be understood as within 10%, 9%, 8%, 7%, 6%, 5%, 4%, 3%, 2%, 1%, 0.5%, 0.1%, 0.05%, or 0.01% of the stated value. Unless otherwise clear from the context, all numerical values provided herein are modified by the term "about."

In describing the present invention, parts that are not related to the description will be omitted. Like reference numerals generally designate like elements throughout the specification. In addition, the size and thickness of each configuration shown in the drawings are arbitrarily shown for better understanding and ease of description, but the present invention is not limited thereto. In the drawings, the thickness of layers, films, panels, regions, etc., are exaggerated for clarity.

Generally, a quick charging method of a battery for an electric vehicle may be classified into a constant current mode (CC mode) and a constant voltage mode (CV mode). When the battery is quick-charged, at an initial state of charging, the battery may be charged in the constant current mode according to a predetermined current map. The battery may be charged in the constant voltage mode after the voltage of the battery reaches a predetermined voltage (for example, about 4.2 V) by charging the battery in the constant current mode. When a state of charge (SOC) of the battery reaches a predetermined level (for example, about 80 %), complete charging of the battery may be determined.

A charging time in the constant current mode may be a time duration for the voltage of the battery to reach the predetermined voltage. Since initial SOC of batteries may be different, the charging time in the constant current mode may vary according to the different batteries. Further, a charging time in the constant voltage mode may be a time from when a voltage of the battery reaches a predetermined voltage (for example, about 4.2 V) to a normal charge condition (for example, an SOC of about 80 %). In other words, the charging time in the constant voltage mode may not be related to initial SOC of the battery. Therefore, the time for maintaining the constant voltage mode may be about the same. However, since the battery may be degraded according to continuous usage, internal resistance of the battery may be increased.

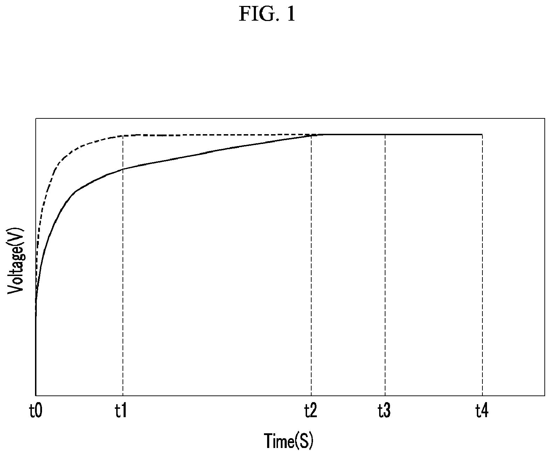

FIG. 1 is an exemplary graph illustrating a time for maintaining a constant voltage mode according to a degradation degree of a battery for an electric vehicle. As shown in FIG. 1, comparing a time for maintaining the constant current mode of a battery that is degraded by about 11 % (refer to the solid line of FIG. 1) with a time for maintaining the constant current mode of a battery that is degraded by about 33 % (refer to the dotted line of FIG. 1), the time for maintaining the constant current mode (tO-tl) of a battery that is degraded by about 11 % is greater than the time for maintaining the constant current mode (t0-t2) of a battery that is degraded by about 33 %.

Further, comparing a time for maintaining the constant voltage mode of a battery that is degraded by about 11 % (refer to the solid line of FIG. 1) with a time for maintaining the constant voltage mode of a battery that is degraded by about 33 % (refer to the dotted line of FIG. 1), the time for maintaining the constant voltage mode (t2-t3) of a battery that is degraded by about 11 % is less than the time for maintaining the constant voltage mode (t1-t4) of a battery that is degraded by about 33 %.

As shown in FIG. 1, the time for maintaining the constant current mode may be decreased and the time for maintaining the voltage current mode may be increased based on the degradation of the battery. A technical feature of the present invention includes determining, by the controller, whether the battery is degraded using the time for maintaining the constant voltage mode that is varied based on the amount of degradation of the battery.

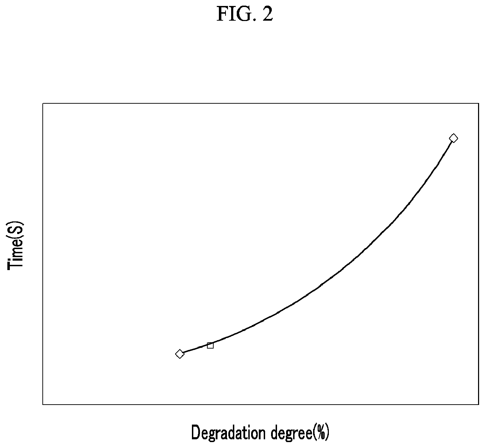

FIG. 2 is an exemplary graph illustrating a relationship of a time for maintaining the constant voltage mode and degradation of the battery for an electric vehicle. As shown in FIG. 2, the time for maintaining the constant voltage mode is exponentially increased according to a degradation degree of the battery. Using this characteristic, a relation equation between the degradation degree of the battery and the time for maintaining the constant voltage mode may be expressed as follows.

Equation 1

$$T = a \cdot e^{b \cdot y}$$

wherein, T is time for maintaining the constant voltage mode, y is the degradation degree of battery, a is a weight value, and b is a weight value.

The degradation degree of the battery may be determined from the time for maintaining the constant voltage mode using Equation 1. In Equation 1, a and b may be determined such that the relation equation may be determined according to a type of vehicle and performance of the battery.

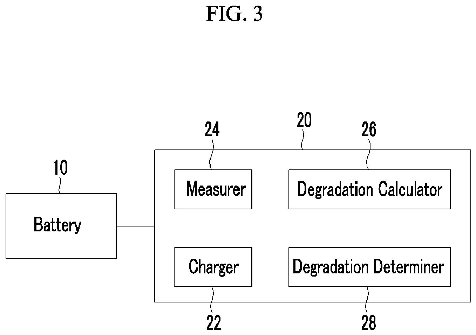

Hereinafter, a battery degradation determining apparatus for an electric vehicle will be described using a relationship between the time for maintaining the constant voltage mode and the degradation degree of the battery. FIG. 3 is an exemplary block diagram illustrating a battery degradation determining apparatus for an electric vehicle according to an exemplary embodiment of the present invention.

As shown in FIG. 3, a battery degradation determining apparatus 20 for an electric vehicle may include a charger 22 configured to charge a battery 10 disposed within an electric vehicle, a measurer 24 configured to measure a time for maintaining the constant voltage mode from the charger 22, a degradation calculator 26 configured to calculate a degradation degree of the battery 10 using the time for maintaining the constant voltage mode measured by the measurer 24, and a degradation determiner 28 configured to determine whether the battery 10 is degraded using a calculated value from the degradation calculator 26. The charger 22, the measurer 24, the degradation calculator 26, and the degradation determiner 28 may be executed by a controller having a processor and a memory.

The charger 22 may be configured to charge the battery using a quick charging method or a slow charging method. According to the quick charging method, the charger 22 may be configured to charge the battery in a constant current mode until a voltage of the battery reaches a predetermined voltage (e.g., a cell voltage of about 4.2 V). When the voltage of the battery 10 reaches the predetermined voltage, the charger 22 may be configured to charge the battery 10 in a constant current mode until the battery satisfies a normal charge condition (e.g., an SOC of about 80 %).

The measurer 24 may be configured to measure a time for maintaining the constant current mode and a time for maintaining the constant voltage mode when the charger 22 charges the battery 10, and the measurer 24 may be configured to measure overall information regarding the battery including current, voltage, temperature, and SOC of the battery. In particular, the time for maintaining the constant current mode may be a time period from the initial charge time to a time when the voltage of the battery reaches the predetermined voltage. The time for maintaining the constant voltage mode may be a time period from the time when the voltage of the battery reaches the predetermined voltage to a time when an SOC of the battery reaches the normal charge condition. The normal charge condition may mean that the SOC of the battery reaches a predetermined SOC.

The degradation calculator 26 may be configured to determine a degradation degree of the battery from the time for maintaining the constant voltage mode measured by the measurer 24. As described above, the time for maintaining the constant voltage mode increases exponentially according to the degradation degree of the battery. Therefore, the degradation degree of the battery may be calculated using Equation 1. In addition, the degradation determiner 28 may be configured to determine whether the battery is degraded using the degradation degree of the battery calculated by the degradation calculator 26. In other words, when the degradation degree of the battery is greater than a predetermined level, the degradation determiner 28 may be configured to determine that the battery is degraded and may provide an alarm to a driver indication the need for an inspection of the battery via an instrument panel of the vehicle. Since the status of the battery may be provided to the driver quantitatively, the driver may establish a strategy for diagnosis of the battery.

Moreover, when the temperature of the battery is too high or low (e.g., greater than a predetermined temperature or less than a predetermined temperature) when the battery is charged, internal resistance of the battery according to the current may vary, and a characteristic of the constant voltage mode may be changed.

Therefore, the degradation degree of the battery may be calculated at room temperature. In addition, the temperature may be in a range of between about 20 degrees and 30 degrees Celsius.

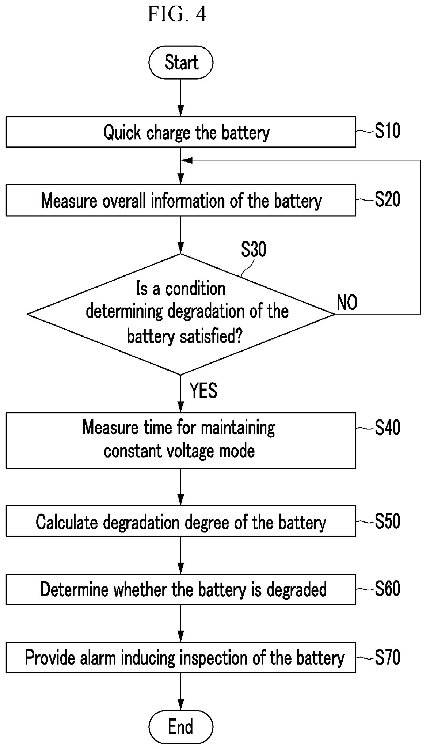

Hereinafter, a determining method of battery degradation for an electric vehicle will be described. FIG. 4 is an exemplary flowchart illustrating a determining method of battery degradation for an electric vehicle according to an exemplary embodiment of the present invention. As shown in FIG. 4, the battery of the electric vehicle may be charged in a quick charge method at step S10. In the quick charge method, the charger 22 may be configured to charge the battery while applying a substantially constant current to the battery based on the constant current mode at the initial time of charging, and the charger 22 may be configured to charge the battery while applying a substantially constant voltage based on the constant voltage mode when the voltage of the battery reaches a predetermined voltage (for example, about 4.2 V).

The measurer 24 may be configured to measure current, voltage, and temperature of the battery using a sensor at step S20. The degradation determiner 28 may be configured to determine whether a condition for determining degradation of the battery is satisfied at step S30. The condition for determining degradation of the battery may be satisfied when the temperature of the battery is about room temperature (e.g., between about 20 degrees and 30 degrees Celsius). When the temperature of the battery is not room temperature (e.g., greater than or less than room temperature), the degradation determiner 28 may not perform a process of determining battery degradation.

Furthermore, the measurer 24 may be configured to measure a time for maintaining the constant voltage mode during quick charge of the battery at step S40. The degradation calculator 26 may be configured to calculate a degradation degree of the battery using the time for maintaining the constant voltage mode at step S50. The degradation degree of the battery may be calculated from Equation 1. The degradation determiner may be configured to determine that the battery is degraded when the degradation degree of the battery is greater than a predetermined level at step S60. When the battery is degraded, the degradation determiner 28 may be configured to output an alarm indicating an inspection of the battery to a driver via the instrument panel of the vehicle at step S70. Accordingly, the driver may determine a diagnostic strategy according to usage of the battery by being provided with the degradation status of the battery.

According to an exemplary embodiment of the present invention, degradation of a battery may be determined quantitatively using a time for maintaining a constant voltage mode when quick charging the battery disposed within an electric vehicle. Further, a diagnosis strategy may be established according to degradation the battery.

**Description of Symbols**

    10: battery
    20: battery degradation determining apparatus
    22: charger
    24: measurer
    26: degradation calculator
    28: degradation determiner

While this invention has been described in connection with what is presently considered to be exemplary embodiments, it is to be understood that the invention is not limited to the disclosed exemplary embodiments, but that the scope of the invention is defined by the accompanying claims.

**Claims**

1. A battery degradation determining apparatus for a vehicle, comprising:

    a charger (22) configured to charge a battery (10) in a constant current mode to a predetermined voltage and to charge the battery (10) in a constant voltage mode when a voltage of the battery (10) reaches the predetermined voltage to a time when an SOC of the battery reaches a predetermined level;
    a measurer (24) configured to measure a time for maintaining the constant voltage mode;
    a degradation calculator (23) configured to calculate a degradation degree of the battery (10) using the measured time for maintaining the constant voltage mode;
    a controller including a processor and a memory configured to store program instructions, wherein the processor is configured to execute the program instructions, the program instructions when executed configured to execute the charger (22), the measurer (24) and the degradation calculator (26), if a condition for determining degradation degree of the battery (10) is satisfied;
    **characterized in that**
    the condition for determining degradation of the battery (10) is satisfied when the temperature of the battery (10) is within a room temperature range.

2. The battery degradation determining apparatus for a vehicle of claim 1, further comprising a degradation determiner (28) configured to determine whether the battery (10) is degraded using the calculated degradation degree of the battery, wherein the program instructions when executed are further configured to execute the degradation determiner (28).

3. The battery degradation determining apparatus for a vehicle of claim 1 or 2, wherein
the time for maintaining the constant voltage mode increases exponentially according to the degradation of the battery (10).

4. A determining method of battery degradation for a vehicle, comprising:

measuring, by a controller, a voltage and a temperature of a battery (10);
determining, by the controller, whether a condition for determining degradation of the battery (10) is satisfied;
charging the battery (10) in a constant current mode to a predetermined voltage;
charging the battery (10) in a constant voltage mode when a voltage of the battery (10) reaches the predetermined voltage to a time when an SOC of the battery reaches a predetermined level;
measuring, by the controller, a time for maintaining the constant voltage mode; and
calculating, by the controller, a degradation degree of the battery (10) from the measured time for maintaining the constant voltage mode;
**characterized in that**
the condition for determining degradation of the battery (10) is satisfied when the temperature of the battery (10) is within a room temperature range.

5. The determining method of battery degradation for a vehicle of claim 4, further comprising:

determining, by the controller, that the battery (10) is degraded when the degradation degree of the battery (10) is greater than a predetermined level; and
outputting, by the controller, an alarm that indicates a required inspection of the battery (10).

6. A non-transitory computer readable medium containing program instructions executed by a controller, the computer readable medium comprising:

program instructions that measure a voltage and a temperature of a battery (10);
program instructions that determine, whether a condition for determining degradation of the battery (10) is satisfied;
program instructions that charge the battery (10) in a constant current mode to a predetermined voltage;
program instructions that charge the battery (10) in a constant voltage mode when a voltage of the battery (10) reaches the predetermined voltage to a time when an SOC of the battery reaches a predetermined level;
program instructions that measure a time for maintaining the constant voltage mode; and
program instructions that calculate a degradation degree of the battery from the measured time for maintaining the constant voltage mode;
**characterized in that**
the condition for determining degradation of the battery (10) is satisfied when the temperature of the battery (10) is within a room temperature range.

7. The non-transitory computer readable medium of claim 6, further comprising:

program instructions that determine that the battery is degraded when the degradation degree of the battery (10) is greater than a predetermined level; and
program instructions that output an alarm that indicates a required inspection of the battery (10).

**Patentansprüche**

1. Batteriedegradation-Bestimmungsvorrichtung für ein Fahrzeug, umfassend:

ein Ladegerät (22), das dazu ausgelegt ist, eine Batterie (10) in einem Modus mit konstantem Strom zu einer vorbestimmten Spannung zu laden und die Batterie (10) in einem Modus mit konstanter Spannung zu laden, wenn eine Spannung der Batterie (10) die vorbestimmte Spannung zu einer Zeit erreicht, wenn ein SOC der Batterie einen vorbestimmten Pegel erreicht;
eine Messvorrichtung (24), die dazu ausgelegt ist, eine Zeit zur Aufrechterhaltung des Modus mit konstanter Spannung zu messen;
einen Degradationskalkulator (23), der dazu ausgelegt ist, einen Degradationsgrad der Batterie (10) unter Verwendung der gemessenen Zeit zur Aufrechterhaltung des Modus mit konstanter Spannung zu berechnen;
eine Steuerung einschließlich eines Prozessors und eines Speichers, der zum Speichern von Programmanweisungen ausgelegt ist, wobei der Prozessor dazu ausgelegt ist, die Programmanweisungen auszuführen, die Programmanweisungen bei Ausführung dazu ausgelegt sind, das Ladegerät (22), die Messvorrichtung (24) und den Degradationskalkulator (26) auszuführen, falls eine Bedingung zur Bestimmung eines Degradationsgrades der Batterie (10) erfüllt ist; **dadurch gekennzeichnet, dass** die Bedingung zur Bestimmung der Degradation der Batterie (10) erfüllt ist, wenn die Temperatur der Batterie (10) innerhalb eines Raumtemperaturbereichs liegt.

2. Batteriedegradation-Bestimmungsvorrichtung für ein Fahrzeug nach Anspruch 1, ferner umfassend:

   eine Degradationsbestimmungsvorrichtung (28), die dazu ausgelegt ist, unter Verwendung des berechneten Degradationsgrades der Batterie zu bestimmen, ob die Batterie (10) degradiert ist,
   wobei die Programmanweisungen bei Ausführung ferner dazu ausgelegt sind, die Degradationsbestimmungsvorrichtung (28) auszuführen.

3. Batteriedegradation-Bestimmungsvorrichtung für ein Fahrzeug nach Anspruch 1 oder 2, wobei sich die Zeit zur Aufrechterhaltung des Modus mit konstanter Spannung entsprechend der Degradation der Batterie (10) exponentiell erhöht.

4. Bestimmungsverfahren der Batteriedegradation für ein Fahrzeug, umfassend:

   Messen, durch eine Steuerung, einer Spannung und einer Temperatur einer Batterie (10);
   Bestimmen, durch die Steuerung, ob eine Bedingung zur Bestimmung der Degradation der Batterie (10) erfüllt ist;
   Laden der Batterie (10) in einem Modus mit konstantem Strom zu einer vorbestimmten Spannung;
   Laden der Batterie (10) in einem Modus mit konstanter Spannung, wenn eine Spannung der Batterie (10) die vorbestimmte Spannung zu einer Zeit erreicht, wenn ein SOC der Batterie einen vorbestimmten Pegel erreicht;
   Messen, durch die Steuerung, einer Zeit zur Aufrechterhaltung des Modus mit konstanter Spannung; und
   Berechnen, durch die Steuerung, eines Degradationsgrades der Batterie (10) aus der gemessenen Zeit zur Aufrechterhaltung des Modus mit konstanter Spannung;
   **dadurch gekennzeichnet, dass** die Bedingung zur Bestimmung der Degradation der Batterie (10) erfüllt ist, wenn die Temperatur der Batterie (10) innerhalb eines Raumtemperaturbereichs liegt.

5. Bestimmungsverfahren der Batteriedegradation für ein Fahrzeug nach Anspruch 4, ferner umfassend:

   Bestimmen, durch die Steuerung, dass die Batterie (10) degradiert ist, wenn der Degradationsgrad der Batterie (10) größer als ein vorbestimmtes Niveau ist; und
Ausgeben, durch die Steuerung, eines Alarms, der eine erforderliche Inspektion der Batterie (10) angibt.

6. Nichtflüchtiges computerlesbares Medium, das Programmanweisungen enthält, die durch eine Steuerung ausgeführt werden, wobei das computerlesbare Medium Folgendes umfasst:

   Programmanweisungen, die eine Spannung und eine Temperatur einer Batterie (10) messen;
   Programmanweisungen, die bestimmen, ob eine Bedingung zur Bestimmung der Degradation der Batterie (10) erfüllt ist;
   Programmanweisungen, die die Batterie (10) in einem Modus mit konstantem Strom zu einer vorbestimmten Spannung laden;
   Programmanweisungen, die die Batterie (10) in einem Modus mit konstanter Spannung laden, wenn eine Spannung der Batterie (10) die vorbestimmte Spannung zu einer Zeit erreicht, wenn ein SOC der Batterie einen vorbestimmten Pegel erreicht;
   Programmanweisungen, die eine Zeit zur Aufrechterhaltung des Modus mit konstanter Spannung messen;
   Programmanweisungen, die einen Degradationsgrad der Batterie aus der gemessenen Zeit zur Aufrechterhaltung des Modus mit konstanter Spannung berechnen;
   **dadurch gekennzeichnet, dass** die Bedingung zur Bestimmung der Degradation der Batterie (10) erfüllt ist, wenn die Temperatur der Batterie (10) innerhalb eines Raumtemperaturbereichs liegt.

7. Nichtflüchtiges computerlesbares Medium nach Anspruch 6, ferner umfassend:

   Programmanweisungen, die bestimmen, dass die Batterie degradiert ist, wenn der Degradationsgrad der Batterie (10) größer als ein vorbestimmtes Niveau ist; und
   Programmanweisungen, die einen Alarm ausgeben, der eine erforderliche Inspektion der Batterie (10) angibt.

**Revendications**

1. Appareil de détermination de dégradation de batterie pour un véhicule comprenant :

   un chargeur (22) configuré pour charger une batterie (10) dans un mode de courant constant à une tension prédéterminée et pour charger la batterie (10) dans un mode de tension constante lorsqu'une tension de la batterie (10) atteint la tension prédéterminée à un moment où un SOC de la batterie atteint un niveau prédéterminé ;

un dispositif de mesure (24) configuré pour mesurer un temps pour conserver le mode de tension constante ;

un calculateur de dégradation (23) configuré pour calculer un degré de dégradation de la batterie (10) à l'aide du temps mesuré pour conserver le mode de tension constante ;

un dispositif de commande comprenant un processeur et une mémoire configurée pour stocker des instructions de programme, dans lequel le processeur est configuré pour exécuter les instructions de programme, les instructions de programme, lorsqu'elles sont exécutées, étant configurées pour exécuter le chargeur (22), le dispositif de mesure (24) et le calculateur de dégradation (26) si une condition pour déterminer un degré de dégradation de la batterie (10) est remplie ;

**caractérisé en ce que**
la condition pour déterminer une dégradation de la batterie (10) est remplie lorsque la température de la batterie (10) se situe dans une plage de température ambiante.

2. Appareil de détermination de dégradation de batterie pour un véhicule selon la revendication 1, comprenant en outre
un dispositif de détermination de dégradation (28) configuré pour déterminer si la batterie (10) est dégradée à l'aide du degré de dégradation calculé de la batterie, dans lequel les instructions de programme, lorsqu'elles sont exécutées, sont en outre configurées pour exécuter le dispositif de détermination de dégradation (28).

3. Appareil de détermination de dégradation de batterie pour un véhicule selon la revendication 1 ou 2, dans lequel
le temps pour conserver le mode de tension constante augmente de manière exponentielle en fonction de la dégradation de la batterie (10).

4. Procédé de détermination d'une dégradation de batterie pour un véhicule, consistant :

à mesurer, au moyen d'un dispositif de commande, une tension et une température d'une batterie (10) ;
à déterminer, au moyen du dispositif de commande, si une condition pour déterminer une dégradation de la batterie (10) est remplie ;
à charger la batterie (10) dans un mode de courant constant à une tension prédéterminée ;
à charger la batterie (10) dans un mode de tension constante lorsqu'une tension de la batterie (10) atteint la tension prédéterminée à un moment où un SOC de la batterie atteint un niveau prédéterminé ;
à mesurer, au moyen du dispositif de commande, un temps pour conserver le mode de tension constante ; et
à calculer, au moyen du dispositif de commande, un degré de dégradation de la batterie (10) à partir du temps mesuré pour conserver le mode de tension constante ;
**caractérisé en ce que**
la condition pour déterminer une dégradation de la batterie (10) est remplie lorsque la température de la batterie (10) se situe dans une plage de température ambiante.

5. Procédé de détermination d'une dégradation de batterie pour un véhicule selon la revendication 4, consistant en outre :

à déterminer, au moyen du dispositif de commande, que la batterie (10) est dégradée lorsque le degré de dégradation de la batterie (10) est supérieur à un niveau prédéterminé ; et
à transmettre, au moyen du dispositif de commande, une alarme qui indique une inspection nécessaire de la batterie (10).

6. Support non transitoire lisible par ordinateur contenant des instructions de programmes exécutées par un dispositif de commande, le support lisible par ordinateur comprenant :

des instruction de programme qui mesurent une tension et une température d'une batterie (10) ;
des instructions de programme qui déterminent si une condition pour déterminer une dégradation de la batterie (10) est remplie ;
des instructions de programme qui chargent la batterie (10) dans un mode de courant constant à une tension prédéterminée ;
des instructions de programme qui chargent la batterie (10) dans un mode de tension constante lorsqu'une tension de la batterie (10) atteint la tension prédéterminée à un moment où un SOC de la batterie atteint un niveau prédéterminé ;
des instructions de programme qui mesurent un temps pour conserver le mode de tension constante ; et
des instructions de programme qui calculent un degré de dégradation de la batterie à partir du temps mesuré pour conserver le mode de tension constante ;
**caractérisé en ce que**
la condition pour déterminer une dégradation de la batterie (10) est remplie lorsque la température de la batterie (10) se situe dans une plage de température ambiante.

7. Support non transitoire lisible par ordinateur selon la revendication 6, comprenant :

des instructions de programme qui déterminent que la batterie est dégradée lorsque le degré de dégradation de la batterie (10) est supérieur à un niveau prédéterminé ; et
des instructions de programme qui transmettent une alarme qui indique une inspection nécessaire de la batterie (10).

FIG. 1

FIG. 2

FIG. 3

24    20    26

10

| Measurer | Degradation Calculator |

Battery

| Charger | Degradation Determiner |

22    28

FIG. 4

```
                    ( Start )
                       │
                       ▼
        ┌──────────────────────────────┐
        │   Quick charge the battery    │──── S10
        └──────────────────────────────┘
                       │
                       ▼ ◄─────────────────────────┐
        ┌──────────────────────────────┐           │
        │ Measure overall information   │──── S20   │
        │        of the battery         │           │
        └──────────────────────────────┘           │
                       │                            │
                       ▼        S30                 │
                     ╱      ╲                       │
                   ╱          ╲                     │
                 ╱  Is a condition ╲                │
                ╱ determining degradation of the ╲  NO
                ╲    battery satisfied?    ╱────────┘
                  ╲                      ╱
                    ╲                  ╱
                       │ YES
                       ▼
        ┌──────────────────────────────┐
        │   Measure time for maintaining │──── S40
        │      constant voltage mode     │
        └──────────────────────────────┘
                       │
                       ▼
        ┌──────────────────────────────┐
        │ Calculate degradation degree  │──── S50
        │        of the battery         │
        └──────────────────────────────┘
                       │
                       ▼
        ┌──────────────────────────────┐
        │ Determine whether the battery │──── S60
        │        is degraded            │
        └──────────────────────────────┘
                       │
                       ▼
        ┌──────────────────────────────┐
        │ Provide alarm inducing        │──── S70
        │  inspection of the battery    │
        └──────────────────────────────┘
                       │
                       ▼
                    ( End )
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2977678 A1
- US 2003071559 A1
- EP 2530478 A2
- US 20010022518 A1